# EUROPEAN PATENT APPLICATION

(11) **EP 2 390 896 A1**
(43) Date of publication of application: **30.11.2011**
(21) Application number: 11167638.3
(22) Date of filing: 26.05.2011
(51) Int. Cl.: H01J 37/063, H01J 37/065, H01J 1/02, G03F 7/20

(54) **Electron gun, lithography apparatus, method of manufacturing article, and electron beam apparatus**

(30) Priority: 28.05.2010 JP 2010122955
(71) Applicant: CANON KABUSHIKI KAISHA, Ohta-ku Tokyo 146-8501 (JP)
(72) Inventor: Imaoka, Nobuo, Ohta-ku, Tokyo (JP)
(74) Representative: Williamson, Brian

(57) **Abstract**

An electron gun includes a cathode (1), a bias electrode (4a,4b), and an anode (6) disposed along a common axis in order thereof. In the electron gun, an electron emitting surface of the cathode has such an aspherical shape that brightness of a crossover is more uniform than that in a case that both a first region including a point on the axis and a second region located outside the first region have a first radius of curvature.

## Description

### BACKGROUND OF THE INVENTION

### Field of the Invention

The present invention relates to an electron gun, a lithography apparatus, a method of manufacturing an article, and an electron beam apparatus.

### Description of the Related Art

Japanese Patent Application Laid-Open No. 2000-285840 discusses an electron gun including a cathode, a bias electrode, and an anode disposed in order along a common axis. This electron gun has an advantage in projecting an electron beam at uniform current density (illuminance) over a wide field of view while maintaining comparatively high brightness.

The electron gun discussed in Japanese Patent Application Laid-Open No. 2000-285840 has an advantage in brightness uniformity of a crossover. However, the inventors of the present application have discovered that, due to a spherical electron emitting surface of the cathode, this electron gun has a limitation in brightness uniformity.

### SUMMARY OF THE INVENTION

The present invention is directed to an electron gun advantageous in terms of brightness uniformity of a crossover thereof.

The present invention in its first aspect provides an electron gun as specified in claims 1 to 6.

The present invention in its second aspect provides a lithography apparatus for exposing a substrate to an electron beam as specified in claims 7 to 10.

The present invention in its third aspect provides a method of manufacturing an article as specified in claims 11.

The present invention in its forth aspect provides an electron beam apparatus configured to project an electron beam to an object as specified in claims 12.

Further features and aspects of the present invention will become apparent from the following detailed description of embodiments with reference to the attached drawings.
[0009A] According to a further aspect of the present invention there is provided an electron gun comprising: a cathode having an electron emitting surface, a bias electrode, and an anode disposed in that order, wherein the electron emitting surface of the cathode has rotational symmetry around a central axis; and wherein the radius of curvature of the electron emitting surface increases as the distance from said central axis increases.

### BRIEF DESCRIPTION OF THE DRAWINGS

The accompanying drawings illustrate embodiments, features, and aspects of the invention and, together with the description, serve to explain the principles of the invention.

Fig. 1 schematically illustrates an electron gun according to a first embodiment of the present invention.

Figs. 2A to 2D each schematically illustrate a shape of an electron emitting surface of a cathode.

Fig. 3 schematically illustrates a structure of a main part of the electron gun of Fig. 1.

Fig. 4 schematically illustrates a trajectory of emitted electrons wherein the electron emitting surface is constituted by a spherical surface.

Figs. 5A to 5E each schematically illustrate a trajectory of electrons emitted from the electron emitting surface according to the first embodiment of the present invention.

Figs. 6A to 6D schematically illustrate other examples of a reference curved surface used to obtain the shape of the electron emitting surface.

Figs 7A and 7B are graphs respectively indicating the brightness uniformity of a conventional electron gun, and the electron gun according to the first embodiment of the present invention.

Fig. 8 schematically illustrates a lithography apparatus according to a second embodiment of the present invention.

### DESCRIPTION OF THE EMBODIMENTS

Various embodiments, features, and aspects of the invention will be described in detail below with reference to the drawings.

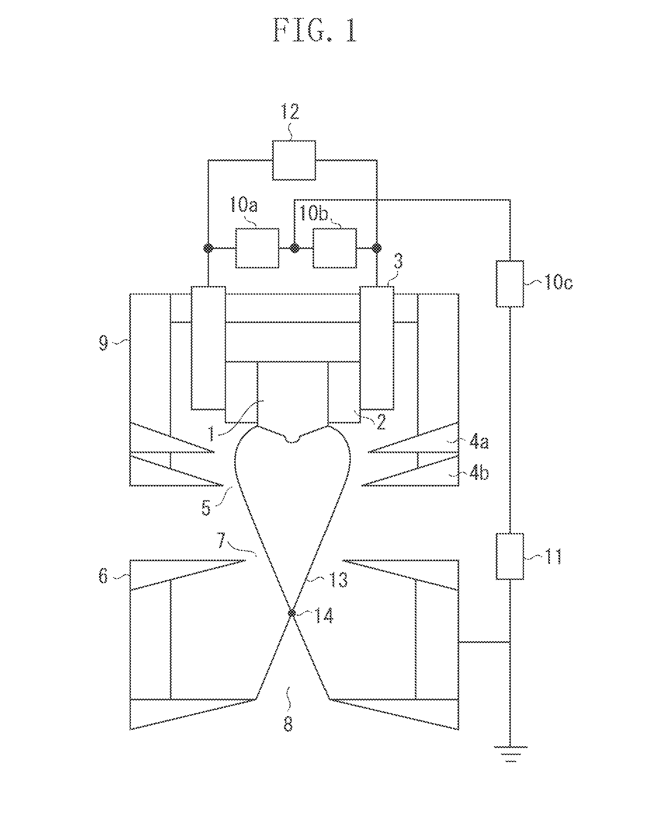

Fig. 1 schematically illustrates a structure of an electron gun according to a first embodiment of the present invention. Referring to Fig. 1, a cathode 1 emits electrons. A heater 2 heats the cathode 1. The cathode 1 and the heater 2 are sandwiched and fixed by a support electrode 3. The support electrode 3 applies a voltage to the cathode 1, and supplies current to the heater 2. A bias electrodes 4a and 4b (a first bias electrode and a second bias electrode) are provided. A first aperture 5 is defined by the bias electrodes 4a and 4b. An anode 6 accelerates electrons emitted from the cathode 1 to attain predetermined energy. A second aperture 7 and a third aperture 8 are defined by the anode 6. An insulator 9 insulates the support electrode 3 from the bias electrodes 4a and 4b. Bias circuits 10a, 10b, and 10c are provided. A high-voltage power source 11 applies a voltage to the cathode 1 via the bias circuits 10a, 10b, and 10c. A heating power source 12 supplies current to the heater 2 to heat the cathode 1. The cathode 1, the bias electrodes 4a and 4b, and the anode 6 are coaxially arranged, and disposed in this order along a common axis (also referred to as "the optical axis of an electron beam"). The cathode 1 is fixed and sandwiched at the side surfaces by the heater 2 (for example, a graphite heater), and further sandwiched from the further outer sides of the heater 2 by the support electrode 3.

The cathode 1 is provided with a negative high potential by the high-voltage power source 11 via the bias circuits 10a, 10b, and 10c. In the present embodiment, this potential is -15 kV. The bias electrodes 4a and 4b are provided with a potential lower by approximately 10 to 100 V than the potential supplied to the cathode 1. The cathode 1 emits electrons when heated by the heater 2 which is provided with current from the heating power supply 12. An electron beam 13, emitted by the cathode 1, is accelerated by the anode 6, and is converged by an electrostatic lens effect exerted by the bias electrodes 4a and 4b, whereby the electron beam 13 forms a crossover 14 beyond the second aperture 7 defined by the anode 6. The third aperture 8 defined by the anode 6 functions as a limit aperture, and shields the periphery of the electron beam 13 to allow a passage of only the center portion of the electron beam 13, which can be regarded to have uniform brightness.

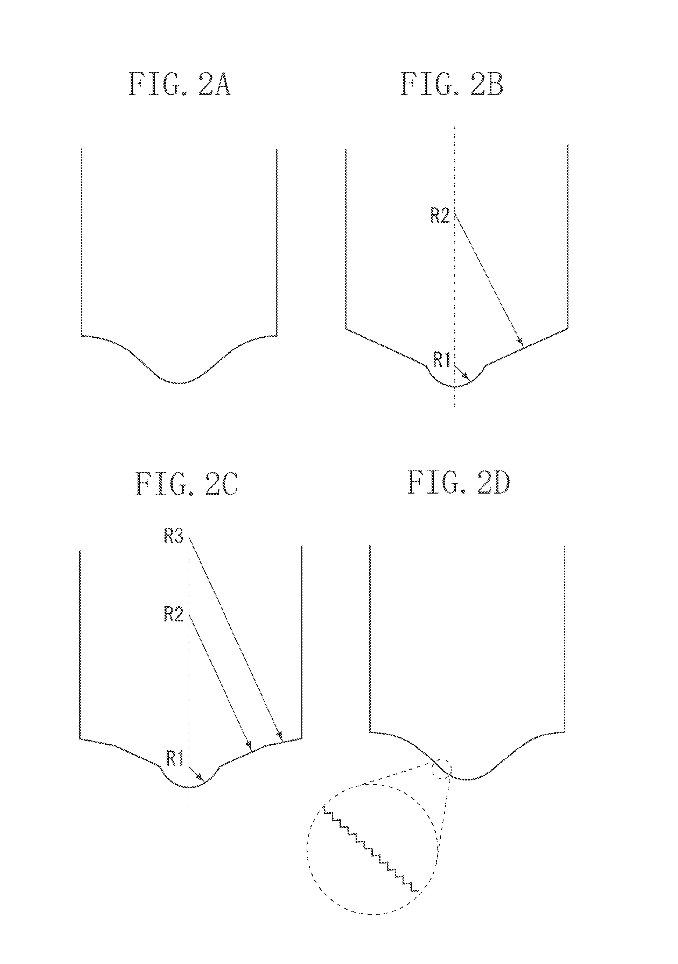

Figs. 2A to 2D each schematically illustrate a shape of an electron emitting surface of the cathode 1 in the electron gun according to the present embodiment. The electron emitting surface of the cathode 1 is processed in such a manner that the radius of curvature thereof is, in a cross-section of the electron gun including the optical axis, increased as a point thereon moves away from a point on the optical axis of the electron emitting surface. The radius of curvature is, for example, obtained at each point thereon as a radius of a spherical surface with which the electron emitting surface is approximated. More specifically, as shown in Fig. 2A, the electron emitting surface has such a shape that the radius of curvature at the point on the optical axis is small, while the radius of curvature increases in a stepwise manner toward the periphery. Alternatively, as illustrated in Figs. 2B and 2C, the electron emitting surface may have a shape having two or three different regions, each with a different radius of curvature, to enable easy processing of the cathode 1 (may be made from a lanthanum hexaboride single crystal for example)to reduce the cost of manufacture. Even this shape can improve brightness uniformity over prior art electron guns. For example, a radius of curvature R1 around the center (optical axis or axis of symmetry) of the electron emitting surface may be 0.03 to 0.3 mm, and the radiuses of curvature R2 and R3 towards the periphery of the electron emitting surface may be 0.4 mm or more. Further, even when the electron emitting surface is shaped as a more ideal aspherical surface, the electron emitting surface may have a stepwise shape (a shape including a step or abrupt change from a first radius of curvature to a second radius of curvature) in a microscopic view, to enable easy processing and/or low production cost of the cathode 1, as in the embodiment illustrated in Fig. 2D.

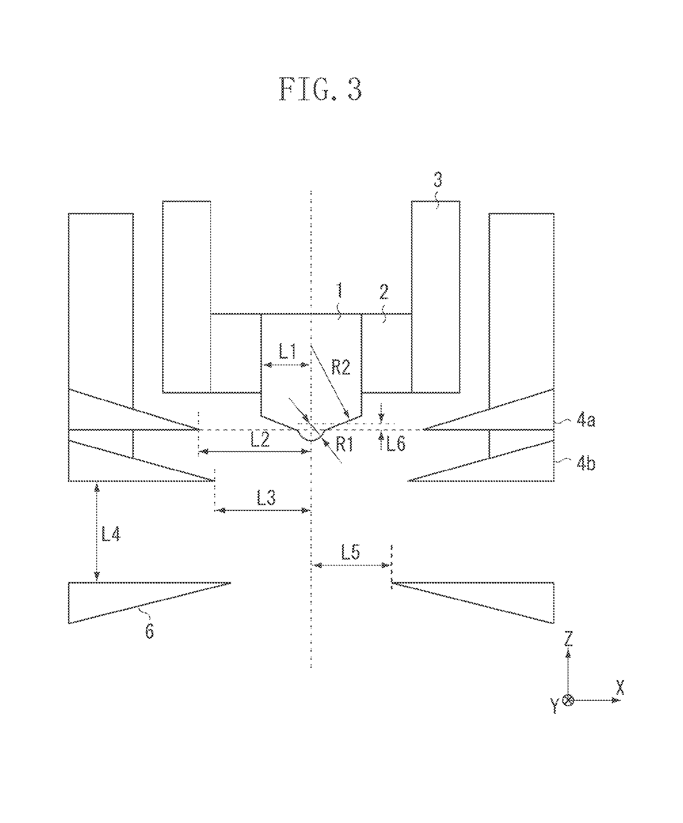

Fig. 3 schematically illustrates the main part of an electron gun in accordance with an embodiment of the present invention. The electron emitting surface of the cathode 1 has radiuses of curvature R1 and R2 according to the above-described values (see Fig. 2B). The bias electrode 4a is disposed to be aligned to the boundary , where the radius of curvature is changed from R1 to R2 in the electron emitting surface, in the Z direction (the direction of the optical axis) as illustrated. For example, if the acceleration voltage of the anode 6 is 15 kV, a suitable size of a cathode radius L1 may be 0.3 to 0.8 mm. Under such conditions, a suitable size of a radius L2 of the aperture of the bias electrode 4a may be 1.1 to 1.3 times larger than L1, and a suitable size of a radius L3 of the aperture of the bias electrode 4b may be 0.7 to 1.0 time larger than L2. A distance L4 between the bias electrode 4b and the anode 6 is approximately 1.5 mm if the electric field intensity is set to 10 kV/mm and the acceleration voltage by the anode 6 is set to 15 kV. The brightness is increased by setting a radius L5 of the aperture of the anode 6 to a small value while ensuring that contact with the electron beam is prevented, and a size of the radius L5 can be 0.05 to 0.2 mm. A distance L6 is a distance from the position of the center of the curvature corresponding to the radius of curvature R1 to the position of the above-described boundary where the radius of curvature is changed from R1 to R2. A positional range of the distance L6 can be -0.01 to -0.03 mm in the Z axis direction (a negative value means that the center of the curvature is located below the boundary). In the present embodiment, the brightness uniformity at the crossover is improved by disposing two bias electrodes as mentioned above. However, the distances between elements (the cathode 1, the anode 6, and the bias electrodes 4a and 4b) may be changed where appropriate, and a plurality of bias electrodes may not be necessary depending on the distances. Further, in the present embodiment, the acceleration voltage by the anode is set to 15 kV which is low compared to a conventional electron gun. This arrangement can reduce the speed of accelerated electrons compared to a conventional electron gun, so that an increase in the temperature of an object (for example, an aperture member) irradiated with the electron beam can be avoided. Further, since this arrangement makes it possible to reduce an absolute value of the potential in the high-voltage portion inside the electron gun and an electron beam apparatus described later, a measure against an electric discharge can be simplified, which is advantageous in that the size and cost of the electron gun or the electron beam apparatus may be reduced.

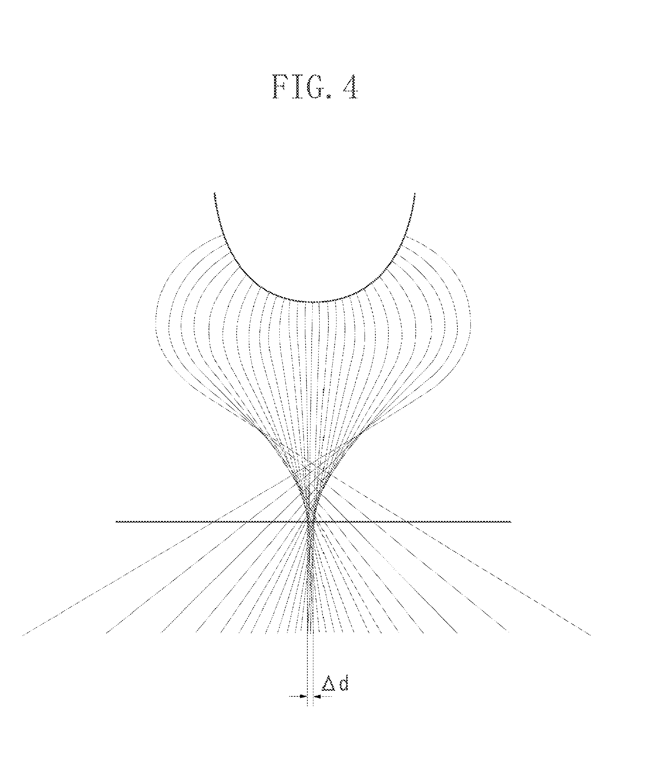

Fig. 4 schematically illustrates a trajectory of electrons in the case that the electron emitting surface of the cathode 1 of the electron gun is a spherical surface. The trajectory of electrons is calculated, assuming that the not-illustrated bias electrodes 4a and 4b and the anode 6 have the preferable potential difference and the preferable positional relationship relative to the cathode 1. The trajectory of electrons emitted from the cathode 1 is uniquely determined under the conditions of this electron difference and this positional relationship. Under these conditions, as the electron emitting position on the electron emitting surface is located farther away from the position on the optical axis and closer to the periphery, the position where the emitted electrons cross the optical axis is shifted toward the cathode side. Therefore, an actual diameter of the crossover is significantly increased at a target crossover position (a position in the Z axis direction), compared to a target crossover diameter Δ d. Therefore, assuming a light (electron) receiving surface is located beyond the crossover (that is further from the cathode than the crossover), then the trajectory of the electrons directed to the light receiving surface tends to be drastically inclined outward as the trajectory is away from the optical axis. Therefore, the current density (illuminance) on the light receiving surface is drastically reduced as the position thereon moves away from the optical axis (as the semiangle of the beam is increased).

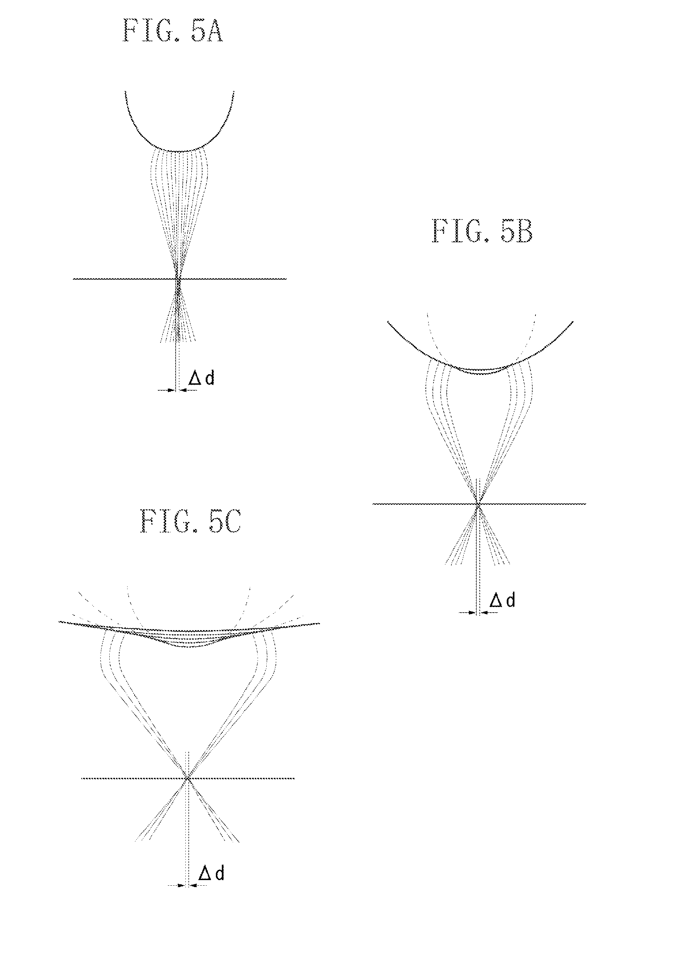

Figs. 5A to 5E each schematically illustrate a trajectory of electrons emitted from the electron emitting surface of the cathode 1 of the electron gun according to the present embodiment. Fig. 5A illustrates a trajectory of electrons emitted from the range (first region), in the spherical electron emitting surface having the same radius (first radius of curvature) as the radius of the electron emitting surface illustrated in Fig. 4, from which electrons emitted have the target crossover diameter Δd at the target crossover position. The electrons emitted from the peripheral side beyond the illustrated range cannot be included within the range of the target crossover diameter Δd at the target crossover position.

Then, the radius of the spherical surface of the electron emitting surface is increased (to a second radius of curvature larger than the first radius of curvature) in the region (second region) outside the range illustrated in Fig. 5A, so that the electrons emitted therefrom fall within the target crossover diameter Δd at the target crossover position (Fig. 5B). In Fig. 5B, the solid line represents a spherical region from which the electrons emitted fall within the target crossover diameter Δd at the target crossover position, and the broken line represents a spherical region from which the electrons emitted do not fall within the target crossover diameter Δd at the target crossover position. The centers of the two spherical surfaces are located on the optical axis. In the XYZ coordinate system illustrated in Fig. 3, the centers of the two spherical surfaces correspond with each other at X and Y coordinates, and not at Z coordinates. The electron emitting surface of the cathode 1 is a surface defined by selecting the regions from the two spherical surfaces that is closer to the anode 6 than the other, and connecting thus-selected regions.

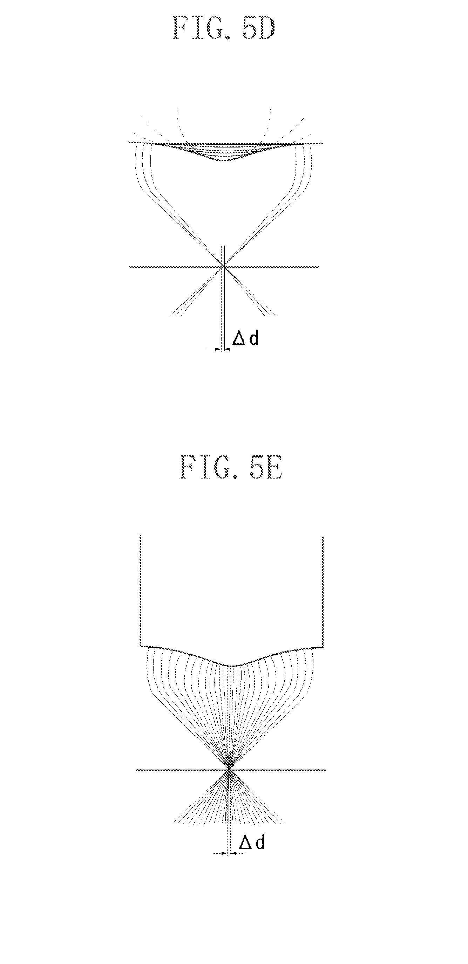

If the radius of the spherical surface on the periphery is too large or too small, the electrons fall within the range of the target crossover diameter Δd at the target crossover position, and therefore the radius should be appropriately set. Then, even if the radius is appropriately set as illustrated in Fig 5B, the region from which the electrons emitted fall within the range of the target crossover diameter Δd at the target crossover position is not so wide. Therefore, as illustrated in Figs. 5C and 5D, partial regions of the electron emitting surface having respective further larger radii should be added as regions (third region, fourth region ...) on the periphery outside the region illustrated in Fig. 5B. By repeating this arrangement, finally the shape of the electron emitting surface of the cathode 1 is generated as illustrated in Fig. 5E. The electron emitting surface of the cathode 1 has such a shape that the radius of curvature is increased in a stepwise or continuous manner as the position thereon is away from the position on the optical axis. In this case, electrons emitted from the electron emitting surface fall within the range of the target crossover diameter Δd at the target crossover position. Owing to this arrangement, the current density on the light receiving surface assumed to be located at the back of the crossover position can be regarded as uniform, without an occurrence of a drastic reduction of the current density as the position is away from the position on the optical axis (as the semiangle of the beam is increased). Further, the trajectory of the electron beam after a passage through a condenser lens disposed on the rear side relative to the electron gun can be regarded as parallel to the optical axis. Therefore, the light receiving surface assumed to be located on the rear side relative to the condenser lens can be regarded as having uniform current density over the whole light receiving region.

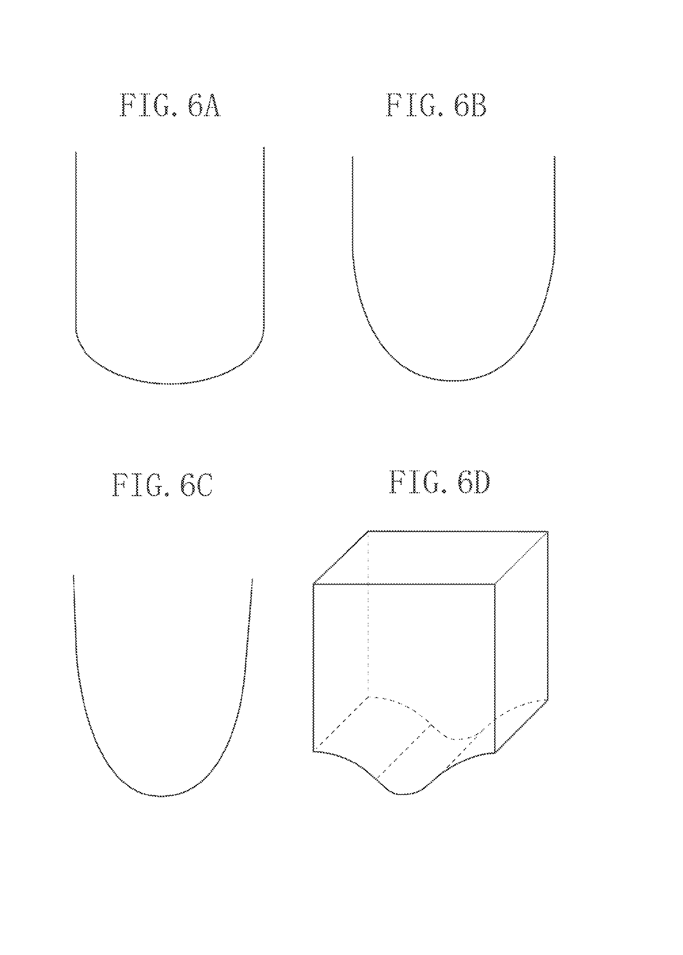

Figs. 6A to 6D each illustrate a reference shape for obtaining a shape (ideal shape) of the electron emitting surface of the cathode 1. The description with reference to Figs. 5A to 5D has disclosed an example of obtaining a shape of the electron emitting surface based on a spherical surface as the reference shape. However, an employable reference shape is not limited to a spherical surface. For example, the shape (ideal shape) of the electron emitting surface may be also obtained based on a shape in the cross-section including the optical axis such as an elliptical shape as illustrated in Fig. 6A, a streamline shape as illustrated in Fig. 6B, and a parabolic shape as illustrated in Fig. 6C. Further, as illustrated Fig. 6D, the shape of the electron emitting surface may be also obtained based on, as a reference shape, a cylindrical surface having an axis parallel to the X axis or the Y axis.

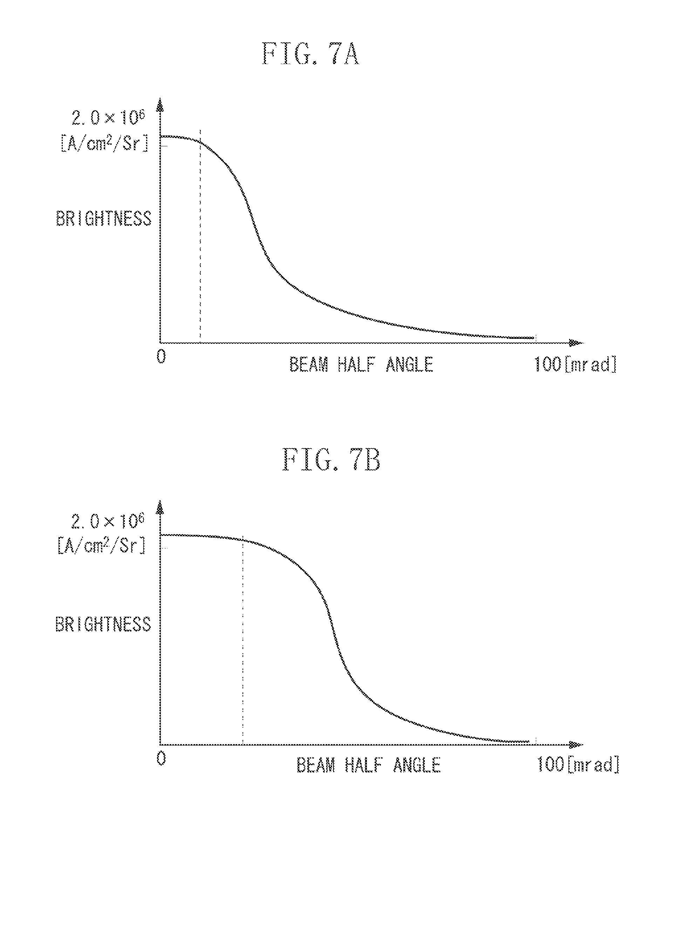

Fig. 7A and 7B each illustrate a graph indicating the characteristic (relationship) of the brightness versus the beam half angle in the electron gun, assuming that the acceleration voltage by the anode 6 is 15 kV. The crossover brightness varies depending on the angle of the direction in which the brightness is observed, relative to the optical axis, and therefore this angle is defined as "beam half angle". Figs. 7A and 7B each illustrate the relationship between this beam half angle and the brightness. Fig. 7A illustrates a graph indicating the characteristic of the relationship of the brightness to the beam half angle if the electron emitting surface is a spherical surface (Fig. 4), while Fig. 7B illustrates a graph indicating the characteristic of the relationship of the brightness to the beam half angle if the electron emitting surface is the surface according to the present embodiment (Fig. 2B). The broken line in the each graph represents the beam half angle value at which the brightness is reduced by 3% from the peak value. This difference of 3% is an example that can be handled as substantially uniform brightness by, for example, an adjustment of an electron optical system in a lithograph apparatus that will be described later. In this example, the beam half angle value at which brightness can be regarded as (substantially) uniform is approximately 3 mrad, if the electron emitting surface is a spherical surface (Fig. 4). On the other hand, the beam half angle capable of maintaining the brightness uniformity can be increased to approximately 20 mrad if the electron emitting surface is the surface according to the present embodiment as illustrated Fig. 2B, and the beam half angle capable of maintaining the brightness uniformity can be increased to approximately 20.5 mrad (not illustrated)if the electron emitting surface is the surface according to the present embodiment as illustrated Fig. 2C.

The present embodiment uses a lanthanum hexaboride (LaB₆) single crystal as the material of the cathode 1. However, the material of the cathode 1 may be another material such as a high-melting-point metal such as tungsten (W), or a compound crystal having a low work function, such as phosphorus (P)-doped diamond.

Further, the present embodiment allows a brightness reduction within 3%, and accepts such brightness as uniform brightness. However, an acceptable amount for a brightness reduction may vary depending on usage of the electron gun (for example, the specifications of an apparatus to which the electron gun is incorporated). For example, a lithography apparatus for manufacturing a mask for a semiconductor exposure apparatus can accept a brightness reduction by up to approximately 10%. Therefore, the electron emitting surface of the cathode 1 of the electron gun may be formed in a shape according to this usage. [In other words, the electron emitting surface may have any shape under which the brightness in the crossover falls within the brightness range (for example, the range from a value corresponding to 97% of maximum brightness to the maximum brightness) acceptable by a lithography apparatus in the range of the semiangle of the beam required for the lithography apparatus into which the electron gun is incorporated. By using the shape of the electron emitting surface according to the present embodiment, uniformity in the brightness can be achieved at the crossover within a predetermined range of the beam half angle, compared to use of the shape (for example, a spherical surface) of the conventional electron emitting surface. Further, it is also possible to broaden the beam half angle range capable of keeping the brightness at the crossover within a predetermined brightness range, compared to a case where the shape (for example, a spherical surface) of the conventional electron emitting surface is used.

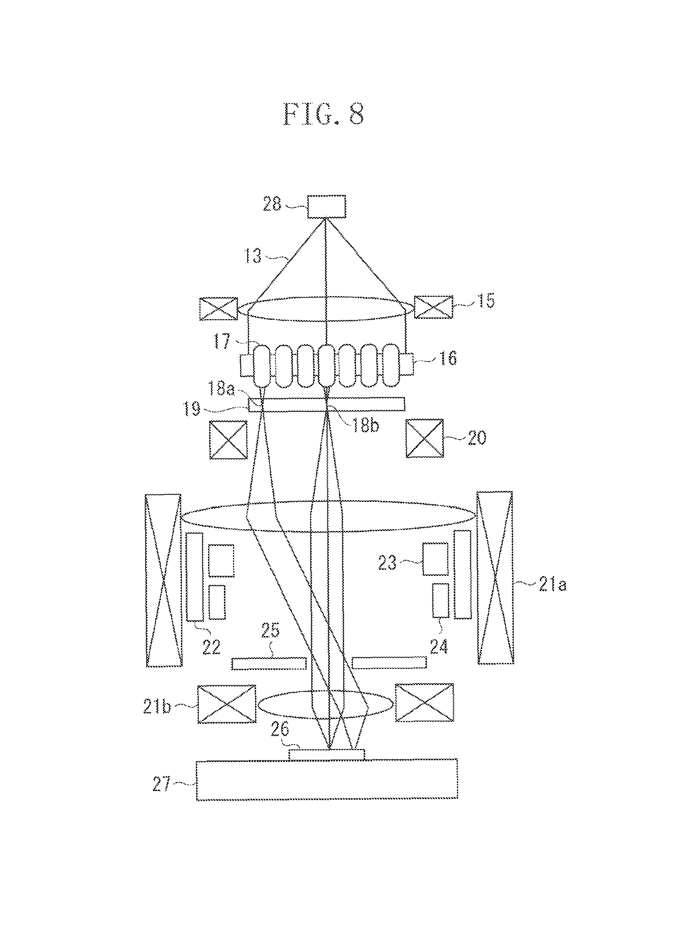

Next, a second embodiment of the present invention will be described. The second embodiment involves a lithography apparatus (electron beam exposure apparatus) into which the electron gun described as the first embodiment is incorporated. Fig. 8 schematically illustrates an overview of a lithography apparatus including the electron gun according to the first embodiment as a light source (electron source). The lithography apparatus draws a latent image pattern by projecting an electron beam via an electron optical system onto a substrate (an object to be lithographed or exposed). The substrate has thereon a photoresist layer where the latent image is generated by projection of the electron beam thereto. Referring to Fig. 8, the electron gun 28 according to the first embodiment functions as a light source of the lithography apparatus. An electron beam emitted from this light source is condensed by a condenser lens 15 (a condenser element included in the electron optical system) having a front-side focal point which coincides with the above-described crossover position so that an electron beam can be regarded as a collimated beam. This substantially collimated electron beam is incident on a shaping system 16 constituted by an array of a plurality of element electron optical systems 17. A plurality of electron beams is generated by the plurality of element electron optical systems 17. Each of the element electron optical systems 17 including a blanking electrode (not illustrated) generates an intermediate image (18a, 18b) of the light source (crossover) in the vicinity of an opening of a blanking aperture array 19. Each of the blanking electrodes deflects the corresponding electron beam by an application of a voltage thereto, and the deflected electron beam is shielded by the blanking aperture 19.

Electromagnetic lenses 21a and 21b constitute a reduced projection system by functioning as a magnetic symmetrical doublet in combination. The reduced projection system includes a limit aperture 25. The distance between the electromagnetic lenses 21a and 21b is equal to the sum of the focal lengths of the respective lenses. The intermediate images 18a and 18b of the light source are formed at the front-side focal position of the electromagnetic lens 21a, and formed again at the rear-side focal position of the electromagnetic lens 21b. In this case, the projection magnification is equal to the ratio of the focal lengths of the electromagnetic lenses 21a and 21b. Further, the electromagnetic lenses 21a and 21b are set so that the magnetic fields thereof act in opposite directions from each other. Therefore, a spherical aberration, astigmatism, a coma aberration, a field curvature, a rotation of an image around the optical axis, and a chromatic aberration of magnification are canceled.

An electromagnetic deflector 23 satisfies moving objective lens (MOL) conditions. An electrostatic deflector 24 performs deflection by an electric field. These two deflectors deflect electron beams from the plurality of intermediate images 18a and 18b, and scan the substrate 26 with the plurality of intermediate images 18a and 18b. The electromagnetic deflector 23 and the electrostatic deflector 24 are selectively used depending on a deflection amount of an electron beam. The electromagnetic deflector 23 is a dynamic focus coil to correct a shift of the focus position which may be caused by an operation of the deflector. The electrostatic deflector 24 is a dynamic stig coil to correct astigmatism which may be caused by the same operation. A stage 27 moves the substrate 26 in the respective axial directions in the X-Y-Z orthogonal coordinate system. The position and speed of the stage 27 is accurately controlled by measuring with a plurality of measuring instruments. The Z axis is an axis parallel to the optical axis of the reduced projection system. The pattern drawing is carried out by projecting a plurality of intermediate images according to pattern data onto the substrate 26 by the reduced projection system. The plurality of intermediate images according to the pattern data is formed by the plurality of element electron optical systems each including the blanking electrode. Further, the pattern drawing is carried out in cooperation with the scanning of an electron beam on the substrate 26 by the electromagnetic deflector 23 and the electrostatic deflector 24, and the movement of the stage 27.

In the present embodiment, the electron emitting surface of the cathode 1 of the electron gun 28 has such a shape that the radius of curvature thereof is increased from the position on the optical axis toward the periphery. Owing to this arrangement, the current density (intensity of a plurality of electron beams) can be regarded as uniform within the region on the substrate 26 where the electron beams are projected. It is difficult to make the electron optical system (electrostatic lens or electromagnetic lens) function as a concave lens without causing a change in energy of electrons. Therefore, it is difficult to arrange the electron optical system so as to correct the ununiformity in the current density (illuminance) on the substrate associated with the brightness ununiformity at the crossover. This problem can be solved by the above-mentioned shape of the electron emitting surface. In other words, it is possible to improve the uniformity in the electric current on the substrate 26 in the lithography apparatus owing to cooperation of the electron gun 28 and the electron optical system.

Generally, a manufactured electron gun and a manufactured electron optical system have a manufacturing error and an aberration. Therefore, it is effective to measure an error (aberration) in each of an electron gun and an electron optical system, and correct an error (aberration) that is difficult to be corrected by adjusting only one of them, by adjusting the other. For example, a cathode in an electron gun can be formed in such a manner that the shape of the electron emitting surface thereof is determined to correct not only brightness ununiformity at the crossover but also an aberration in the electron optical system, and the shape of the electron emitting surface conforms to the determined shape. The lithography apparatus according to the present embodiment includes a single electron gun. However, the lithography apparatus may be a multicolumn-type lithography apparatus including a plurality of electron guns and a plurality of electron optical systems corresponding to the electron guns. Further, the electron gun according to the present embodiment can be also applied to an electron beam apparatus that is not a lithography apparatus, such as an electron microscope.

Next, an article (for example, a liquid crystal display device, an optical element, and a mask for a lithography apparatus (exposure apparatus)) manufacturing method, which is an embodiment of the present invention, will be described as a third embodiment taking a semiconductor device by way of example. The semiconductor device is manufactured by performing a front-end process of forming an integrated circuit on a wafer (substrate), and a back-end process of completing the integrated circuit formed on the wafer in the front-end process as a product. The front-end process includes a process of applying lithography to the wafer, which is coated with a resist (photosensitizing agent), with an electron beam using the above-described lithography apparatus (electron beam exposure apparatus), and a process of developing the wafer subjected to the lithography process. The back-end process includes an assembling process (dicing and bonding) and a packaging process (encapsulation). The article manufacturing method according to the present embodiment is advantageous in terms of at least one of the performance and quality of a resulting article, productivity, and manufacturing cost, compared to a conventional method.

While desirable embodiments of the present invention have been described above, it is to be understood that the invention is not limited to the disclosed embodiments. Any modification or variation within the scope of the invention should be possible. For example, the above description has defined the shape of the electron emitting surface of the cathode by the magnitude relation between the radius of curvature of the first region and the radius of curvature of the second region. However, the shape of the electron emitting surface of the cathode may be any aspherical shape determined based on an electric field generated in the electron gun so as to achieve better brightness uniformity of the crossover, than that of an electron gun in which both the first region and the second region have a first radius of curvature (i.e. so that a brightness of a crossover of the electron gun is more uniform than that in a case that the electron emitting surface has a spherical shape).

While the present invention has been described with reference to embodiments, it is to be understood that the invention is not limited to the disclosed exemplary embodiments.

## Claims

1. An electron gun comprising:
a cathode (1) having an electron emitting surface, a bias electrode (4a, 4b), and an anode (6) disposed in that order along a common axis thereof,
wherein the electron emitting surface has an aspherical shape so that a brightness of a crossover of the electron gun is more uniform than that in a case that the electron emitting surface has a spherical shape.

2. The electron gun according to claim 1, wherein the electron emitting surface of the cathode (1) comprises, at least, two regions, each of which having a radius of curvature,
wherein the radius of curvature of said at least two regions increases as the distance from said axis to the region increases.

3. The electron gun according to claim 1, further comprising:
an aperture (8) configured to shield an electron beam (13) produced by the cathode (1) beyond the crossover (14) so as to limit a semiangle of the electron beam (13).

4. The electron gun according to claim 2, wherein the electron emitting surface has a shape including an abrupt boundary between said at least two regions.

5. The electron gun according to claim 4, wherein the bias electrode (4a, 4b) includes a first bias electrode (4a) and a second bias electrode (4b) disposed in order along said axis,
wherein the first bias electrode (4a) is disposed in line with a boundary between the first region and the second region in the direction of the axis.

6. A lithography apparatus for exposing a substrate (26) to an electron beam (13), the apparatus comprising:
an electron gun, as claimed in any one of preceding claims, configured to generate an electron beam (13); and
an electron optical system (17) configured to irradiate a substrate with the generated electron beam (13).

7. The apparatus according to claim 6, wherein the electron optical system (17) includes a condenser element (15) configured to condense the electron beam (13).

8. The apparatus according to claim 7, wherein the electron emitting surface has such a shape that the electron beam produced by the cathode (1) is collimated beyond the condenser element (15).

9. The apparatus according to claim 6 or 7, wherein the electron emitting surface has such a shape that an aberration of the electron optical system (17) is compensated for.

10. A method of manufacturing an article, the method comprising:
exposing a substrate (26) to an electron beam (13) using a lithography apparatus as claimed in any one of claims 6-9;
developing the exposed substrate; and
processing the developed substrate to manufacture the article.

11. An electron beam apparatus for irradiating an object with an electron beam (13), the apparatus comprising:
an electron gun, as claimed in any one of claims 1-5, configured to generate the electron beam (13); and
an electron optical system (17)configured to irradiate the object (26) with the generated electron beam (13).
